# FASCICULE DE BREVET EUROPEEN

(11) **EP 0 536 028 B1**
(45) Date de publication et mention de la délivrance du brevet: **25.03.1998**
(21) Numéro de dépôt: 92402636.2
(22) Date de dépôt: 25.09.1992
(51) Int. Cl.: G06F 11/26, H03K 5/13

(54) **Méthode de compensation automatique des incertitudes de temps d'un système électronique testé par un testeur automatique**
Verfahren zur automatischen Kompensation der Zeitunsicherheiten eines elektronischen Systems, das von einem Prüfautomaten geprüft wird
Method to automatically compensate the time uncertainties of an electronic system tested by an automatic tester

(30) Priorité: 04.10.1991 FR 9112259
(43) Date de publication de la demande: 07.04.1993
(73) Titulaire: AEROSPATIALE Société Nationale Industrielle, 75781 Paris Cédex 16 (FR)
(72) Inventeur: Raygot, Christian, F-92320 Chatillon (FR); Loriette, Guy, F-94170 Le Perreux (FR)
(74) Mandataire: Joly, Jean-Jacques

(56) Documents cités:
- EP-A- 0 356 967
- DE-A- 3 910 508
- IBM TECHNICAL DISCLOSURE BULLETIN. vol. 27, no. 7A, Décembre 1984, NEW YORK, US, pages 3835 - 3838 D. C. YOUNG ET AL. 'Adaptive test timing characterization'

## Description

La présente invention concerne une méthode applicable au test d'un système électronique quelconque, par exemple une carte ou un composant, par un testeur automatique.

Lors du test automatique de systèmes électroniques réalisant une même fonction, une des difficultés majeures réside dans la variation, d'un système à un autre, du temps de propagation existant entre les entrées et les sorties de chaque système. En effet, cette variation qui dépend des temps de propagation propres aux différents éléments qui composent le système ou bien encore de conditions extérieures comme par exemple la température amène des incertitudes quant à la présence d'un changement d'état logique sur une sortie par rapport à l'apparition d'un tel changement sur les entrées. Il en résulte une diminution des instants pendant lesquels les signaux de sortie du système sont observables et donc mesurables. Une méthode de test tenant compte de cette variation est décrite dans D.C. Young et al.: "Adaptive test timing characterization", IBM Technical Disclosure Bulletin, Vol. 27, no 7A, Décembre 1984, New-York, USA, pages 3835-3838.

Une autre difficulté est liée au testeur même qui possède ses propres incertitudes temporelles apparaissant tant au niveau de ses signaux de stimulation que de ceux de mesure des réponses à ces stimulis. En effet, ces incertitudes, se rajoutant aux précédentes, diminuent encore les instants d'observabilité des signaux de sortie, c'est-à-dire les fenêtres de mesure de ces signaux, et peuvent aboutir par leur cumul à une disparition totale de ces instants indispensables à l'analyse du système électronique testé.

La présente invention a pour but de remédier à ces difficultés par la détermination puis la compensation automatique de ces différentes incertitudes de temps sans utilisation spécifique d'appareil de mesure de temps.

Le but est atteint par une méthode de compensation automatique des incertitudes de temps d'un système électronique par un testeur automatique délivrant au moins un signal d'entrée pour le système et recueillant les signaux de sortie issus de ce système à des instants de mesure déterminés par des fenêtres de mesure, comportant, conformément à l'invention, les étapes successives suivantes :
(a) décalage d'un pas déterminé des signaux d'entrée, ou respectivement des fenêtres de mesure, jusqu'à un instant t₁ de coïncidence de ces fenêtres de mesure avec les signaux de sortie du système,
(b) décalage du pas déterminé des signaux d'entrée, ou respectivement des fenêtres de mesure, jusqu'à un instant suivant t₂ de non-coïncidence de ces fenêtres de mesure avec les signaux de sortie du système,
(c) détermination d'un temps de compensation optimal des incertitudes du système, lequel temps est compris entre les instants t₁ et t₂ prédéfinis.

Selon une caractéristique, le décalage des signaux d'entrée est un décalage avant de tout ou partie des signaux d'entrée du système ou bien un décalage arrière de tout ou partie des signaux d'entrée du système.

Selon une autre caractéristique, le décalage des fenêtres de mesure est un décalage arrière de l'ensemble des fenêtres de mesure ou bien un décalage avant de l'ensemble des fenêtres de mesure, le décalage des signaux d'entrée et le décalage des fenêtres de mesure peuvent être réalisés simultanément.

De façon préférentielle, le temps de compensation optimal est donné par la demi-somme des instants t₁ et t₂.

Toutefois, la présente méthode peut ne pas comporter l'étape (b), le temps de compensation optimal de l'étape (c) étant alors pris égal à l'instant t₁ de coïncidence ou un instant suivant séparé seulement de quelques pas de décalage.

De même, il peut également ne pas être déterminé l'instant t₁ de l'étape (a), le temps de compensation optimal de l'étape (c) étant alors pris égal à l'instant t₂ de non-coïncidence ou un instant précédent séparé seulement de quelques pas de décalage.

Ainsi, par cette méthode, il est toujours possible de placer des fenêtres de mesure sur l'ensemble des signaux de sortie et donc d'optimiser leur observabilité quelles que soient les incertitudes existantes tant au niveau du système électronique à tester qu'au niveau du testeur automatique.

D'autres caractéristiques et avantages ressortiront mieux à ta lecture de ta description qui va suivre, faite à titre indicatif et non limitatif, en référence aux dessins annexés sur lesquels :
- les figures 1A à 1G montrent quelques formes d'ondes en entrée et en sortie du testeur ainsi que te positionnement des fenêtres de mesure des sorties ;
- les figures 2A à 2G représentent les signaux des figures 1A à 1G dans un premier mode de réalisation après un premier décalage arrière des signaux d'entrée ;
- les figures 3A à 3G représentent les signaux des figures 1A à 1G après observation d'une première coïncidence des signaux de sortie avec les fenêtres de mesure ;
- les figures 4A à 4G représentent les signaux des figures 1A à 1G après un nouveau décalage arrière des signaux d'entrée ;
- les figures 5A à 5G représentent les signaux des figures 1A à 1G après observation d'une première non-coïncidence des signaux de sortie avec les fenêtres de mesure ;
- les figures 6A à 6G représentent les signaux des figures 1A à 1G après te positionnement définitif des fenêtres de mesure;
- les figures 7A à 7G représentent les signaux des figures 1A à 1G dans un second mode de réalisation après un premier décalage avant des fenêtres de mesure ;
- les figures 8A à 8G représentent les signaux des figures 1A à 1G après observation d'une première coïncidence des signaux de sortie avec les fenêtres de mesure ;
- les figures 9A à 9G représentent les signaux des figures 1A à 1G après un nouveau décalage avant des fenêtres de mesure ;
- les figures 10A à 10G représentent les signaux des figures 1A à 1G après observation d'une première non-coïncidence des signaux de sortie avec les fenêtres de mesure ;
- les figures 11A à 11G représentent les signaux des figures 1A à 1G après le positionnement définitif des fenêtres de mesure ;
- la figure 12 représente un organigramme fonctionnel détaillant les différentes étapes nécessaires à la mise en oeuvre de la méthode ;
- la figure 13 représente un schéma synoptique des moyens de mise en oeuvre de la méthode selon l'invention.

On appellera "évènement" tout changement d'état logique d'une entrée ou d'une sortie ou d'un signal interne au système électronique à tester.

Lors du test d'un système électronique, on choisit un certain nombre de ces évènements qui sont représentatifs du fonctionnement global du système et on vérifie que ceux-ci répondent parfaitement à l'analyse préalable qui en a été faite. La correspondance entre l'analyse et la mesure entraîne la qualification du composant, de la carte ou du sous-ensemble testé, la non-coïncidence entraîne son rejet.

Dans le but de clarifier les explications, le système testé ne comportera que trois entrées, e₀, e₁ et e₂, et deux sorties, s₀ et s₁, et seule une entrée, par exemple e₀, influera sur les sorties s₀ et s₁. Mais, il est évident qu'il ne s'agit aucunement d'une limitation de la méthode proposée et que celle-ci s'applique parfaitement à un nombre quelconque d'entrées ou de sorties, de même qu'elle prend en compte l'influence simultanée sur les sorties de plusieurs entrées.

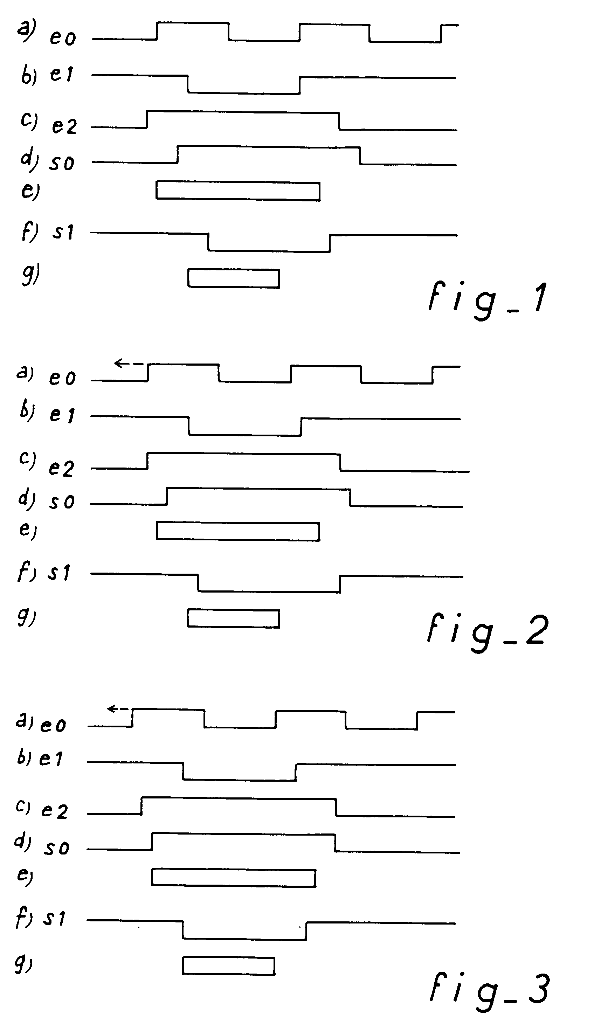

Les figures 1A à 1G montrent les différentes formes d'ondes des signaux en entrée et en sortie du système testé ainsi que le positionnement à l'origine des fenêtres de mesure du testeur automatique.

Les signaux e₀ (figure 1A) e₁ (figure 1B) et e₂ (figure 1C) sont des signaux numériques quelconques, périodiques ou non, représentatifs du fonctionnement global du système à tester. Les signaux s₀ (figure 1D) et s₁ (figure 1F) sont des signaux numériques dont les états dépendent des signaux d'entrée et qui, en l'espèce, correspondent à deux sorties mais pourraient tout aussi bien être des signaux internes au système.

L'emplacement des fenêtres de mesure sur les sorties s₀ (figure 1E) et s₁ (figure 1G) est obtenu depuis une analyse du système à tester, la détermination des diagrammes de temps qui lient entrées et sorties permettant la définition de ces instants théoriques de mesure des sorties pendant lesquels celles-ci prennent une valeur déterminée.

Dans l'exemple considéré, on supposera que les valeurs théoriques des sorties s₀ et s₁ sont respectivement 1 et 0. A l'origine, il peut y avoir coïncidence entre les valeurs théoriques attendues et les valeurs mesurées, mais en général ce n'est pas le cas comme le montrent les figures 1E et 1G pour lesquelles il peut être observé que les signaux s₀ et s₁ changent d'état à l'intérieur de leur fenêtre de mesure respective.

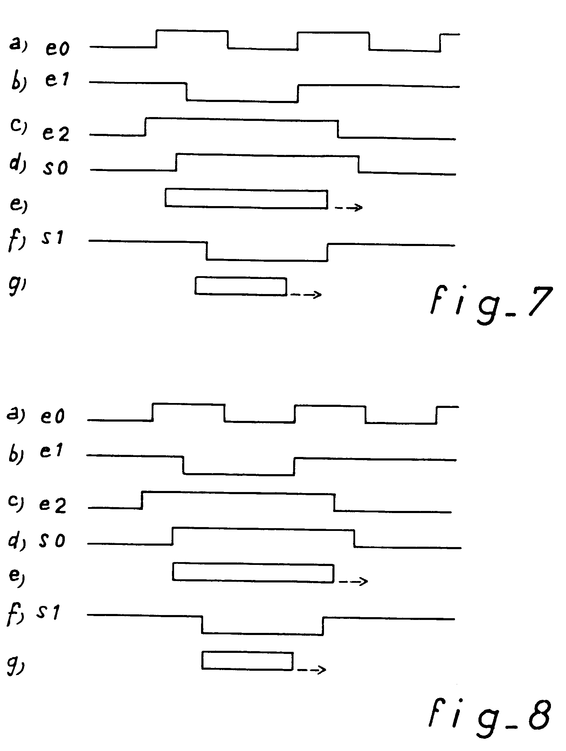

La méthode proposée consiste, par un décalage, d'un pas déterminé dépendant de la précision désirée, des signaux d'entrée ou bien encore des fenêtres de mesure des sorties, à faire coïncider les valeurs théoriques attendues avec les valeurs réellement mesurées. Un premier mode de réalisation consistant dans le décalage de tout ou partie des entrées sera décrit en référence aux figures 2 à 6 et un second mode de réalisation mettant en oeuvre le décalage des fenêtres de mesure de sortie sera décrit plus avant en regard des figures 7 à 11. Un autre mode de réalisation qui consisterait en un décalage à la fois des entrées et des fenêtres de mesure ne sera quant à lui pas décrit.

Dans le premier mode de réalisation, il sera fait état uniquement d'un décalage arrière des signaux d'entrée, mais il est évident que la méthode décrite s'applique pareillement avec un décalage avant. De même, comme il a été précisé précédemment, ce décalage ne sera appliqué qu'au seul signal e₀. S'il avait été supposé que plusieurs entrées pouvaient influencer les signaux de sortie, il aurait été nécessaire de procéder à un décalage uniforme de l'ensemble de ces entrées.

Les figures 2A à 2G montrent l'ensemble des signaux d'entrée et de sortie, ainsi que le positionnement des fenêtres de mesure de s₀ et s₁ après un premier décalage arrière de l'entrée e₀. Les entrées e₁ et e₂ ne bougent pas et s₀ et s₁ se décalent en arrière comme e₀. Les deux fenêtres de mesure restent inchangées et, comme à l'origine, il peut y être observé un changement d'état des sorties qui ne présentent donc pas encore, après ce premier décalage, les valeurs théoriques (1, 0) attendues.

Les figures 3A à 3G montrent les mêmes signaux et fenêtres que précédemment après un ou plusieurs nouveaux décalages aboutissant à l'observation d'une première coïncidence entre les valeurs mesurées et les valeurs théoriques attendues pour les sorties s₀ et s₁. Les signaux e₁ et e₂ n'ont toujours pas bougé et les sorties s₀ et s₁ se sont décalées en arrière comme le signal e₀ mais surtout les fenêtres de mesure qui n'ont pas non plus bougé permettent l'observation d'un état stable des sorties s₀ et s₁, lequel état (1, 0) correspond à celui attendu et déterminé précédemment par l'analyse du système.

Ainsi, après un certain nombre de décalages des signaux d'entrée, on obtient une valeur de décalage temporel de ces signaux, par exemple t₁, pour laquelle les fenêtres de mesure coïncident avec les signaux de sortie du système à tester.

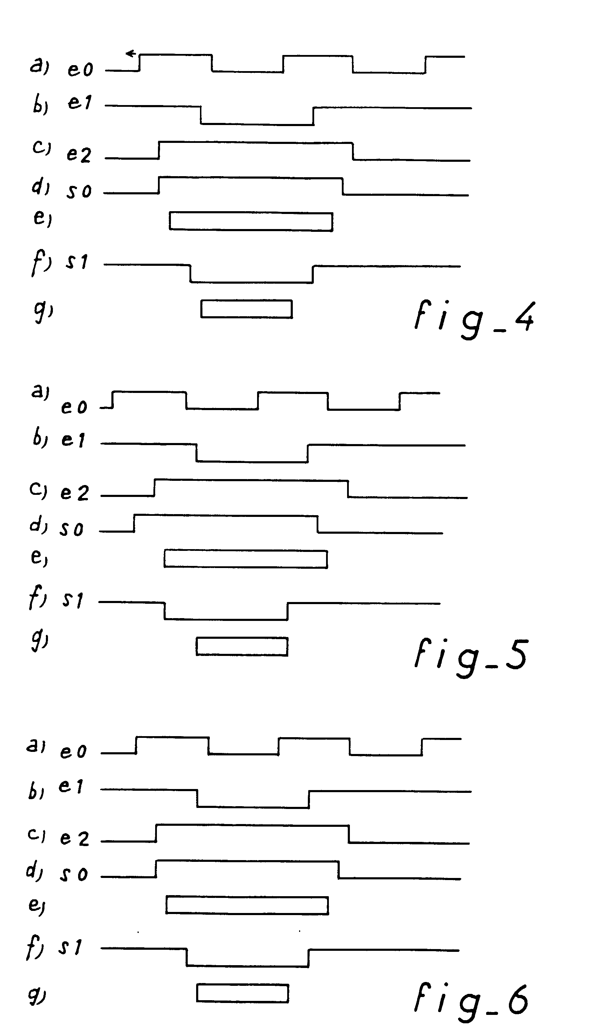

Les figures 4A à 4G montrent à nouveau les signaux et fenêtres précédents lorsqu'un décalage arrière supplémentaire de e₀ est pratiqué. Comme précédemment, seuls s₀ et s₁ se déplacent et il peut n'être observé aucun changement dans l'état des sorties apparaissant dans les deux fenêtres de mesure. Cette étape n'existe pas toujours et il est possible que ce seul décalage provoque un changement d'état des sorties au niveau des fenêtres de mesure comme le montrent les figures 5A à 5G qui correspondent à l'observation d'une première non-coïncidence entre les valeurs théoriques attendues et obtenues précédemment (voir figure 3) et les valeurs mesurées. Ainsi, après un certain nombre de décalages supplémentaires des signaux d'entrée, on obtient une nouvelle valeur de décalage temporel de ces signaux, par exemple t₂ plus grande que t₁, et pour laquelle les fenêtres de mesure ne coïncident plus avec les signaux de sortie du système à tester.

Le décalage optimum des signaux d'entrée permettant d'obtenir une observabilité maximum des signaux de sortie du système sera donné par une valeur t comprise entre t₁ et t₂, par exemple la demi-somme de t₁ et t₂, qui correspond au temps optimal de compensation recherché pour s'affranchir des incertitudes de temps pouvant exister entre différents systèmes réalisant une même fonction. Les figures 6A à 6G et notamment les figures 6E et 6G montrent le positionnement optimal des fenêtres de mesure des sorties s₀ et s₁ obtenu par un décalage optimal de e₀.

Dans le second mode de réalisation, il sera fait état uniquement d'un décalage avant des fenêtres de mesure des signaux de sortie, mais il est bien évident que la méthode décrite s'applique également avec un décalage arrière.

Les formes d'ondes des signaux ainsi que le positionnement des fenêtres à l'origine sont inchangés et conformes aux figures 1A à 1G.

Les figures 7A à 7G montrent ces signaux d'entrée et de sortie ainsi que le positionnement des fenêtres de mesure après un premier décalage avant de celles-ci. Les signaux d'entrée e₀ à e₂ et de sortie s₀ et s₁ sont maintenant inchangés et seules les fenêtres de mesure de ces deux sorties se déplacent vers l'avant. Comme à l'origine, les sorties s₀ et s₁ présentent un changement d'état dans les fenêtres de mesure.

Les figures 8A à 8G représentent à nouveau signaux et fenêtres après un à plusieurs nouveaux décalages avant des fenêtres de mesure aboutissant à l'observation d'une première coïncidence entre les valeurs théoriques attendues pour les sorties s₀ et s₁, à savoir l'état (1, 0) et les valeurs mesurées, ces sorties comme les entrées restant inchangées. Le décalage temporel des fenêtres de mesure existant lors de cette coïncidence est t₁ (identique à t₁ obtenu précédemment, les signaux étant identiques).

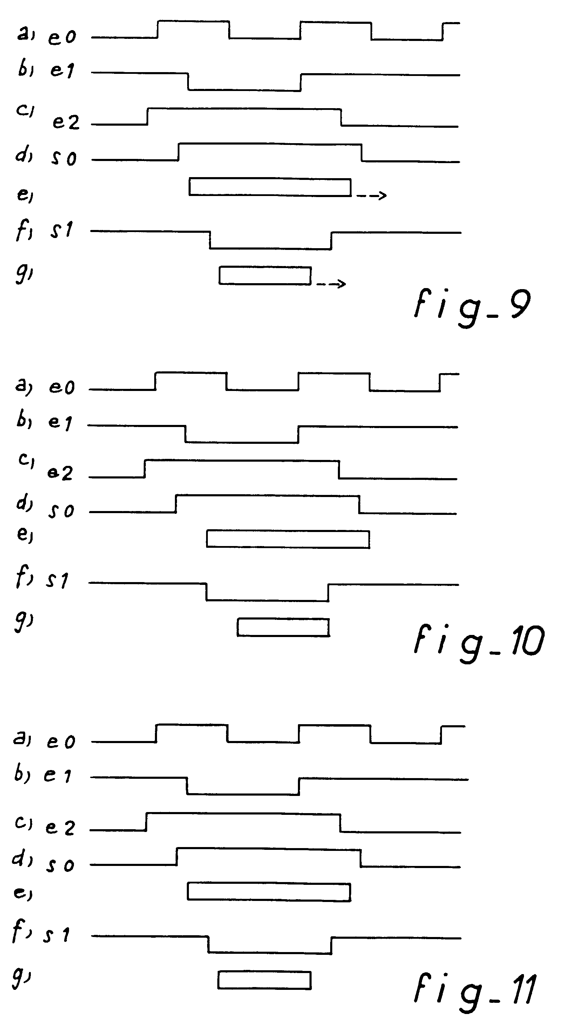

Un nouveau décalage avant des fenêtres de mesure donnera les formes d'ondes des figures 9A à 9G dans lesquelles les sorties s₀ et s₁ présentent toujours un état de sortie stable dans leur fenêtre de mesure respective.

Les figures 10A à 10G sont obtenues après observation d'une première non-coïncidence suivant la détermination de la coïncidence précédente. Elle peut être observée après un (et dans ce cas l'étape précédente n'existe pas) ou plusieurs décalages avant réalisés après la survenance de la première coïncidence. Entrées et sorties restent inchangées mais ces dernières changent d'état dans les fenêtres de mesure, déterminant une nouvelle valeur du décalage temporel de ces fenêtres, t₂ (ici encore égal au t₂ précédent).

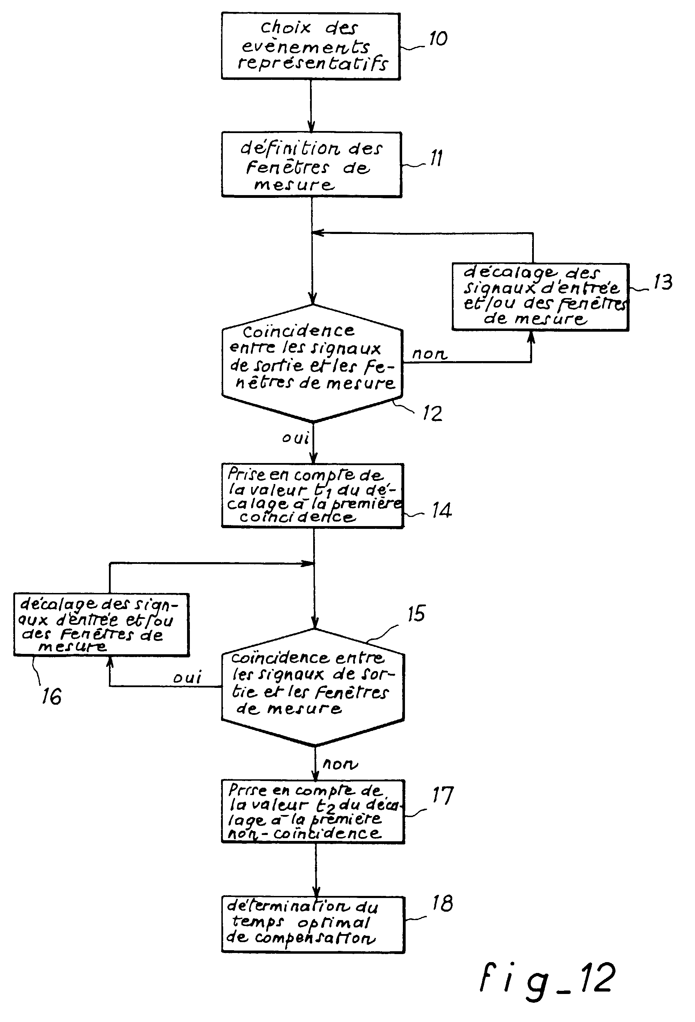

Le décalage optimum des fenêtres de mesure sera alors obtenu pour une valeur comprise entre t₁ et t₂ par exemple celle définie par la demi-somme de t₁ et t₂. Les figures 11A à 11G montrent ce positionnement optimum des fenêtres de mesure par rapport aux signaux de sortie régissant le système à tester, lequel positionnement est bien sûr analogue à celui des figures 6A à 6G.

Les étapes précédentes peuvent encore être décrites en référence à la figure 12 qui montre bien leur succession et précise ainsi la mise en oeuvre de la méthode précitée.

Tout d'abord, on choisit les évènements représentatifs du fonctionnement global du système qui seront ensuite exécutés dans un module spécifique du testeur 10, puis on procède à la définition des fenêtres de mesure depuis l'analyse théorique du système à tester 11. Alors, tant que l'on n'observe pas de coïncidence entre les fenêtres de mesure et les signaux de sortie 12, il est procédé au décalage des signaux d'entrée et/ou des fenêtres de mesure 13. Lorsque cette première coïncidence survient, la valeur du décalage correspondant t₁ est prise en compte 14 puis à nouveau, tant que n'apparaît pas une non-coïncidence entre les fenêtres de mesure et les signaux de sortie 15, il est procédé à un décalage respectivement des signaux d'entrée et/ou des fenêtres de mesure 16. L'apparition de la première non-coïncidence entraîne la prise en compte du décalage temporel t₂ correspondant 17, la détermination d'une valeur de ce décalage comprise entre ces deux extrêmes t₁ et t₂ donnera le temps optimal de compensation des incertitudes de temps 18 qui sera alors appliqué à un ou plusieurs modules spécifiques du testeur destinés au test de l'ensemble du système électronique concerné. La précision de la mesure dépendra de la valeur de l'incrément de temps de décalage, des temps faibles permettant évidemment une meilleure observabilité. Celle-ci peut aussi être améliorée en vérifiant que les valeurs t₁ et t₂ sont stables malgré l'instabilité intrinsèque pouvant exister au niveau des signaux d'entrée délivrés par le testeur. Ceci est possible en effectuant plusieurs mesures de t₁ et t₂ au niveau d'un même système électronique.

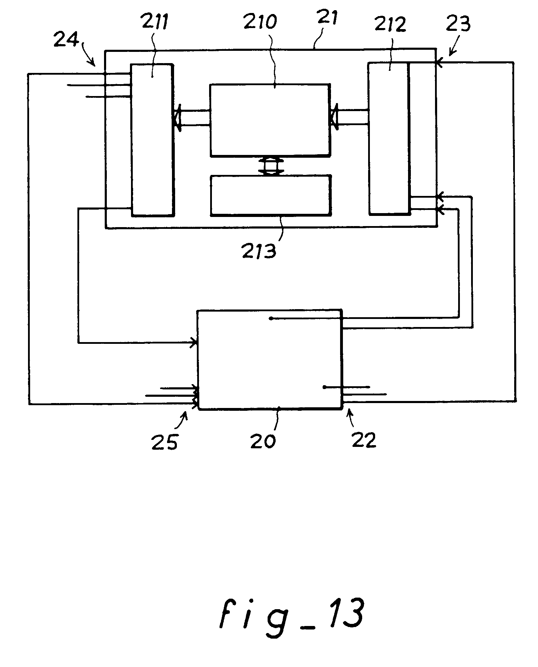

La figure 13 donne un schéma synoptique des moyens nécessaires à la mise en oeuvre de cette méthode de compensation automatique des incertitudes. Un système électronique quelconque 20 est relié directement à un testeur automatique 21. Les sorties 22 du système électronique (sorties externes ou signaux internes) sont reliées aux entrées de mesure 23 du testeur dont les sorties de stimulation 24 constituent les entrées 25 du système électronique à tester (les entrées sont les évènements représentatifs de son fonctionnement global). Le testeur est organisé autour d'une unité de traitement 210 et comporte notamment un module spécifique 211 qui exécute, par l'intermédiaire des sorties de stimulation 24, les évènements des entrées 25 et un module de mesure 212 qui reçoit, par l'intermédiaire des entrées de mesure 23, les évènements des sorties 22 du système électronique à tester, à destination de l'unité de traitement. Un organe de stockage 213 contient les données et les programmes de test, lesquels programmes permettront notamment par l'intermédiaire de l'unité de traitement le décalage temporel de certains signaux exécutés par le module spécifique 211.

La méthode qui vient d'être exposée est particulièrement efficace pour optimiser le test dynamique des systèmes électroniques,notamment les cartes, dans la mesure où elle permet un placement rigoureux des instants de mesure. Elle permet en outre, de s'affranchir des incertitudes liées au décalage existant entre un oscillateur et les horloges élaborées depuis cet oscillateur.

Enfin, de par la grande flexibilité des moyens mis en oeuvre, cette méthode peut se réduire à la simple recherche de la première coïncidence entre les fenêtres de mesure et l'état attendu des signaux de sortie.

Le temps optimal de compensation sera alors égal au temps t₁ correspondant ou, éventuellement dans un souci de sécurité, à un temps légèrement supérieur, par exemple d'un ou de quelques pas de décalage, selon la précision désirée. De même, il est possible de ne pas déterminer l'instant de la première coïncidence et de rechercher simplement la première non-coïncidence apparaissant après une première coïncidence et d'attribuer alors au temps optimal de compensation ce temps t₂ de non-coïncidence ou éventuellement un temps légèrement inférieur, par exemple d'un ou quelques pas de décalage.

## Revendications

1. Méthode de compensation automatique des incertitudes de temps d'un système électronique pour un testeur automatique délivrant au moins un signal d'entrée pour le système et recueillant les signaux de sortie issus de ce système à des instants de mesure déterminés par des fenêtres de mesure, caractérisée en ce qu'elle comporte les étapes successives suivantes :
(a) décalage d'un pas déterminé des signaux d'entrée, ou respectivement des fenêtres de mesure, jusqu'à un instant t₁ de coïncidence de ces fenêtres de mesure avec les signaux de sortie du système,
(b) décalage du pas déterminé des signaux d'entrée, ou respectivement des fenêtres de mesure, jusqu'à un instant suivant t₂ de non-coïncidence de ces fenêtres de mesure avec les signaux de sortie du système,
(c) détermination d'un temps de compensation optimal des incertitudes du système, lequel temps est compris entre les instants t₁ et t₂ prédéfinis.

2. Méthode selon la revendication 1, caractérisée en ce que le décalage des signaux d'entrée est un décalage avant de tout ou partie des signaux d'entrée du système.

3. Méthode selon la revendication 1, caractérisée en ce que le décalage des signaux d'entrée est un décalage arrière de tout ou partie des signaux d'entrée du système.

4. Méthode selon la revendication 1, caractérisée en ce que le décalage des fenêtres de mesure est un décalage arrière de l'ensemble des fenêtres de mesure.

5. Méthode selon la revendication 1, caractérisée en ce que le décalage des fenêtres de mesure est un décalage avant de l'ensemble des fenêtres de mesure.

6. Méthode selon la revendication 1, caractérisée en ce que le décalage des signaux d'entrée et le décalage des fenêtres de mesure peuvent être réalisés simultanément.

7. Méthode selon l'une quelconque des revendications 1 à 6, caractérisée en ce que te temps de compensation optimal est donné par ta demi-somme des instants t₁ et t₂.

8. Méthode de compensation automatique des incertitudes de temps d'un système électronique pour un testeur automatique délivrant au moins un signal d'entrée pour te système et recueillant les signaux de sortie issus de ce système à des instants de mesure déterminés par des fenêtres de mesure, caractérisée en ce qu'elle comporte les étapes successives suivantes :
(a) décalage d'un pas déterminé des signaux d'entrée, ou respectivement des fenêtres de mesure, jusqu'à un instant t₁ de coïncidence de ces fenêtres de mesure avec les signaux de sortie du système,
(b) détermination d'un temps de compensation optimal des incertitudes du système, lequel temps est égal à l'instant t₁ prédéfini ou un instant suivant séparé seulement de quelques pas de décalage.

9. Méthode de compensation automatique des incertitudes de temps d'un système électronique pour un testeur automatique délivrant au moins un signal d'entrée pour te système et recueillant les signaux de sortie issus de ce système à des instants de mesure déterminés par des fenêtres de mesure, caractérisée en ce qu'elle comporte les étapes successives suivantes :
(a) décalage d'un pas déterminé des signaux d'entrée, ou respectivement des fenêtres de mesure, jusqu'à un instant de coïncidence de ces fenêtres de mesure avec les signaux de sortie du système,
(b) décalage du pas déterminé des signaux d'entrée, ou respectivement des fenêtres de mesure, jusqu'à un instant suivant t₂ de non-coïncidence de ces fenêtres de mesure avec les signaux de sortie du système,
(c) détermination d'un temps de compensation optimal des incertitudes du système, lequel temps est égal à l'instant t₂ prédéfini ou un instant précédent séparé seulement de quelques pas de décalage.

## Patentansprüche

1. Verfahren zum automatischen Kompensieren der Zeitunsicherheiten eines elektronischen Systems für einen automatischen Tester, der wenigstens ein Eingangssignal für das System ausgibt und die Ausgangssignale von diesem System zu Meßzeitpunkten, vorgegeben durch Meßfenster, einliest,
dadurch gekennzeichnet, daß
es die folgenden sukzessiven Schritte umfaßt:
(a) Verschieben um einen vorgegebenen Schritt von Eingangssignalen oder bzw. von Meßfenstern bis zu einem Zeitpunkt t₁ der Koinzidenz dieser Meßfenster mit den Ausgangssignalen des Systems,
(b) Verschieben um den vorgegebenen Schritt von Eingangssignalen oder bzw. von Meßfenstern bis zu einem nachfolgenden Zeitpunkt t₂ der Nichtkoinzidenz dieser Meßfenster mit den Ausgangssignalen des Systems,
(c) Bestimmung einer optimalen Kompensationszeit von Unsicherheiten des Systems, wobei diese Zeit zwischen den vordefinierten Zeitpunkten t₁ und t₂ liegt.

2. Verfahren nach Anspruch 1, dadurch gekennzeichnet, daß die Verschiebung von Eingangssignalen eine Verschiebung nach vorne aller oder eines Teils der Eingangssignale des Systems ist.

3. Verfahren nach Anspruch 1, dadurch gekennzeichnet, daß die Verschiebung von Eingangssignalen eine Verschiebung nach hinten aller oder eines Teils der Eingangssignale des Systems ist.

4. Verfahren nach Anspruch 1, dadurch gekennzeichnet, daß die Verschiebung von Meßfenstern eine Verschiebung nach hinten der Gruppe von Meßfenstern ist.

5. Verfahren nach Anspruch 1, dadurch gekennzeichnet, daß die Verschiebung von Meßfenstern eine Verschiebung nach vorne der Gruppe von Meßfenstern ist.

6. Verfahren nach Anspruch 1, dadurch gekennzeichnet, daß die Verschiebung von Eingangssignalen und die Verschiebung von Meßfenstern simultan erfolgen kann.

7. Verfahren nach einem der Ansprüche 1 bis 6, dadurch gekennzeichnet, daß die optimale Kompensationszeit gegeben ist durch den Mittelwert der Zeitpunkte t₁ und t₂.

8. Verfahren zum automatischen Kompensieren der Zeitunsicherheiten eines elektronischen Systems für einen automatischen Tester, der wenigstens ein Eingangssignal für das System ausgibt und die Ausgangssignale von dessen System zu Meßzeitpunkten, vorgegeben durch Meßfenster, einliest, dadurch gekennzeichnet, daß es die folgenden sukzessiven Schritte umfaßt:
(a) Verschieben um einen vorgegebenen Schritt von Eingangssignalen oder bzw. Meßfenstern bis zu einem Zeitpunkt t₁ der Koinzidenz von diesen Meßfenstern mit den Ausgangssignalen des Systems,
(b) Bestimmen einer optimalen Kompensationszeit von Unsicherheiten des Systems, wobei die Zeit gleich einem vorgegebenen Zeitpunkt t₁ oder einem nachfolgenden Zeitpunkt ist, der nur um einige Verschiebungsschritte getrennt ist.

9. Verfahren zum automatischen Kompensieren der Zeitunsicherheiten eines elektronischen Systems für einen automatischen Tester, der wenigstens ein Eingangssignal für das System ausgibt und die Ausgangssignale von diesem System zu Meßzeitpunkten, vorgegeben durch Meßfenster, einliest, dadurch gekennzeichnet, daß es die folgenden sukzessiven Schritte umfaßt:
(a) Verschieben um einen vorgegebenen Schritt von Eingangssignalen oder bzw. von Meßfenstern bis zu einem Zeitpunkt der Koinzidenz von diesen Meßfenstern mit den Ausgangssignalen des Systems,
(b) Verschieben um den vorgegebenen Schritt von Eingangssignalen oder bzw. Meßfenstern bis zu einem nachfolgenden Zeitpunkt t₂ der Nichtkoinzidenz von diesen Meßfenstern mit den Ausgangssignalen des Systems,
(c) Bestimmen einer optimalen Kompensationszeit von Unsicherheiten des Systems, wobei diese Zeit gleich dem vordefinierten Zeitpunkt t₂ oder einem vorangehenden Zeitpunkt ist, der nur um einige Verschiebungsschritte getrennt ist.

## Claims

1. Method for automatically compensating for the time uncertainties of an electronic system in respect of an automatic tester delivering at least one input signal in respect of the system and gathering the output signals from this system at measurement instants determined by measurement windows, characterized in that it includes the following successive phases:
(a) shifting of the input signals, or of the measurement windows respectively, by a specified step, up to an instant t₁ of coincidence of these measurement windows with the output signals from the system,
(b) shifting of the input signals, or of the measurement windows respectively, by the specified step, up to a following instant t₂ of non-coincidence of these measurement windows with the output signals from the system,
(c) determination of a time for optimal compensation of the uncertainties of the system, which time lies between the predefined instants t₁ and t₂.

2. Method according to Claim 1, characterized in that the shifting of the input signals is a forward shifting of all or some of the input signals of the system.

3. Method according to Claim 1, characterized in that the shifting of the input signals is a backward shifting of all or some of the input signals of the system.

4. Method according to Claim 1, characterized in that the shifting of the measurement windows is a backward shifting of all of the measurement windows.

5. Method according to Claim 1, characterized in that the shifting of the measurement windows is a forward shifting of all of the measurement windows.

6. Method according to Claim 1, characterized in that the shifting of the input signals and the shifting of the measurement windows can be carried out simultaneously.

7. Method according to any one of Claims 1 to 6, characterized in that the optimal compensation time is given by the half-sum of the instants t₁ and t₂.

8. Method for automatically compensating for the time uncertainties of an electronic system in respect of an automatic tester delivering at least one input signal in respect of the system and gathering the output signals from this system at measurement instants determined by measurement windows, characterized in that it includes the following successive phases:
(a) shifting of the input signals, or of the measurement windows respectively, by a specified step, up to an instant t₁ of coincidence of these measurement windows with the output signals from the system,
(b) determination of a time for optimal compensation of the uncertainties of the system, which time is equal to the predefined instant t₁ or a following instant separated only by a few shifting steps.

9. Method for automatically compensating for the time uncertainties of an electronic system in respect of an automatic tester delivering at least one input signal in respect of the system and gathering the output signals from this system at measurement instants determined by measurement windows, characterized in that it includes the following successive phases:
(a) shifting of the input signals, or of the measurement windows respectively, by a specified step, up to an instant of coincidence of these measurement windows with the output signals from the system,
(b) shifting of the input signals, or of the measurement windows respectively, by the specified step, up to a following instant t₂ of non-coincidence of these measurement windows with the output signals from the system,
(c) determination of a time for optimal compensation of the uncertainties of the system, which time is equal to the predefined instant t₂ or a preceding instant separated only by a few shifting steps.
